## Europäisches Patentamt
## European Patent Office
## Office européen des brevets

(19)

(11) Veröffentlichungsnummer: **0 000 923**
A1

(12) **EUROPÄISCHE PATENTANMELDUNG**

(21) Anmeldenummer: **78100680.4**

(22) Anmeldetag: **16.08.78**

(51) Int. Cl.²: **G 01 R 1/20,** G 01 R 11/00, H 01 R 13/66

(30) Priorität: **29.08.77 DE 2738853**

(43) Veröffentlichungstag der Anmeldung: **07.03.79** Patentblatt **79/5**

(84) Benannte Vertragsstaaten: **CH DE FR GB**

(71) Anmelder: **SIEMENS AKTIENGESELLSCHAFT Berlin und München, Postfach 261, D-8000 München 22 (DE)**

(72) Erfinder: **Dinse, Gerhard, Sophienstrasse 98, D-8520 Erlangen (DE)**
Erfinder: **Seibt, Artur, Dr., Händelstrasse 28, D-8501 Schwaig (DE)**

(54) **Gerät zum Erfassen, Messen und Anzeigen des Energieverbrauchs elektrischer Verbraucher.**

(57) Das Gerät ist geeignet den Energieverbrauch eines einzelnen Verbrauchers oder einer speziellen Verbrauchergruppe zu messen, indem es diesem vorgeschaltet wird. Das Gerät enthält einen nach einem an sich bekannten Prinzip arbeitenden Elektrizitätszähler, wobei das Gehäuse an der Vorderseite ausser mit einem Fenster (4) zum Ablesen der kWh noch mit einer Steckdose (2) zum Anschalten des Verbrauchers versehen ist. An der Rückseite des Gerätes (1) ist vorzugsweise ein Schukostecker ausgebildet zum Einstecken in eine normale Schukosteckdose.

EP 0 000 923 A1

SIEMENS AKTIENGESELLSCHAFT
Berlin und München

Unser Zeichen:
VPA 77 P 3 1 9 4 BRD

0000923

**Gerät zum Erfassen, Messen und Anzeigen des Energieverbrauchs elektrischer Verbraucher**

Im Zuge eines steigenden Energiebewußtseins ist es notwendig, daß sich die Verbraucher elektrischer Energie darüber klar sind, wie viel die einzelnen bei ihnen eingesetzten Geräte tatsächlich verbrauchen, bevor sie Maßnahmen zur Energieeinsparung treffen können. Zumindest in den Haushalten ist es nicht bekannt, wie viel beispielsweise Kühlschränke, Fernsehgeräte, Gefriertruhen, Umwälzpumpen usw. tatsächlich verbrauchen, da diese stets intermittierend arbeiten, so daß die Angaben auf dem Leistungsschild selbst für einen Fachmann praktisch keinen Anhaltspunkt für den tatsächlichen Verbrauch geben. Zwar kann der Verbrauch eines Einzelgerätes mit Hilfe des in jedem Haushalt vorhandenen Elektrizitätszählers des Elektrizitätsversorgungsunternehmens bestimmt werden, was allerdings voraussetzt, daß tatsächlich alle übrigen Lasten vom Netz abgetrennt sind. Vielfach ist jedoch unbekannt, daß Antennenverstärker, Umwälzpumpen usw. ständig angeschlossen sind, so daß eine derartige Messung mit großer Unsicherheit behaftet ist. Die besonders wichtige Erfassung des Verbrauchs intermittierend arbeitender Geräte ist auf diese Weise kaum möglich, da man schwerlich einen halben oder ganzen Tag außer dem zu messenden Einzelgerät nichts einschalten kann; eine Messung über kürzere Zeit ist aber hierbei praktisch wertlos.

Der Erfindung liegt die Aufgabe zugrunde, ein einfach handzuhabendes Gerät zu schaffen, mit dem der Energieverbrauch eines

Hs 2 Scl, 24.8.1977

einzelnen Verbrauchers oder einer speziellen Verbrauchergruppe erfaßt, gemessen und angezeigt werden kann. Das Gerät gemäß der Erfindung ist dadurch gekennzeichnet, daß es ein nach einem an sich bekannten Prinzip arbeitendes Ein- oder Mehrphasenmeßwerk enthält, speziell einem einzelnen Verbraucher oder einer speziellen Verbrauchergruppe zugeordnet ist und nur den Verbrauch dieses einen Verbrauchers bzw. Verbrauchergruppe erfaßt, mißt oder anzeigt.

Ein solches Gerät stellt im wesentlichen einen Ein- oder Dreiphasenzähler dar. Bei einer bevorzugten Ausführungsform ist das Gerät mit einem Schukostecker und einer Schukosteckdose versehen, so daß es zwischen einer spannungsführenden Schukosteckdose und einem Anschlußstecker eines zu messenden Verbrauchers einschaltbar ist. Besonders vorteilhaft ist, daß ein sogenanntes steckerfertiges Gehäuse verwendet ist, das auf einer Seite einen Schukostecker als Eingang für das Ein- oder Mehrphasenmeßwerk und auf einer anderen Seite eine Schukosteckdose zum Anschluß des zu messenden Verbrauchers aufweist.

Ein solches sogenanntes Kompaktgerät kann unmittelbar in eine Steckdose gesteckt werden, während der zu messende Verbraucher mit seiner Zuleitung direkt in die Steckdose des Gerätes eingesteckt wird. Das Gerät selbst weist keinerlei Bedienungselemente auf, sondern enthält lediglich eine kWh-Anzeige. Eine Fehlbedienung ist daher ausgeschlossen. Da das Gerät vorzugsweise mit einem Isogehäuse ausgestattet ist, ist es berührungssicher und kann daher unbedenklich von Jedermann benutzt werden.

Um jedoch eine kleine und lagenunabhängige Bauweise des Meßsystems zu erzielen, wird gemäß einer Weiterbildung ein elektronisches Meßwerk zur Erfassung des Energieverbrauchs verwendet. Derartige Meßwerke haben zudem den Vorteil, daß sie einen niedrigen Eigenverbrauch aufweisen, was wiederum wegen der begrenzten Wärmeabfuhr zu einer kleineren Bauweise des Gerätes führen kann. Die hierfür geeigneten elektronischen Meßwerke sind hinreichend bei den sogenannten elektronischen Zählern bekannt geworden.

Als Zählwerk wird vorzugsweise ein Rollenzählwerk verwendet, wie es von Ferrariszählern her bekannt ist: der Antrieb erfolgt dabei durch einen Schrittmotor oder durch einen Klappanker mit Steigrad. Um dem Benutzer das Notieren des Zählerstandes und die Differenzbildung zu ersparen, wird in einer weiteren Ausgestaltung der Erfindung ein rückstellbares Zählwerk verwendet. Die Rückstellung kann dabei manuell oder elektrisch erfolgen. Zur Anzeige kann aber auch ein Zählwerk verwendet sein, das sich automatisch rückstellt, sowie der Zähler an Spannung gelegt wird. Es ist aber jede bekannte Anzeigeeinrichtung verwendbar, die elektrisch ansteuerbar ist, insbesondere auch eine elektronische Digitalanzeige mit Leuchtdioden, Flüssigkristallen und so weiter.

In einer weiteren Ausgestaltung der Erfindung kann das Gerät so gestaltet sein, daß es unmittelbar in Maschinen oder Geräte eingebaut oder an diese angebaut werden kann, um deren Energieverbrauch zu messen. Es kann dann vielfach die üblichen Betriebsstundenzähler ersetzen und einen Anreiz zu energiesparendem Betrieb geben..

Gemäß einer weiteren Ausgestaltung der Erfindung kann das Gerät als fester Bestandteil in Haushaltgeräten, wie Waschmaschinen, Wäschetrockner, elektrische Heizgeräte usw., eingebaut sein. Sofern derartige Geräte über eine elektronische Anzeige verfügen, kann diese für die Energieanzeige mitbenutzt werden. Da solche Anzeigen in der Regel nicht speichern, muß dann allerdings ein nichtflüchtiger Speicher vorgesehen sein, wenn man auf eine ständige Kumulierung des Energieverbrauchs Wert legt. Sofern zur Steuerung eines solchen Gerätes ein Computer verwendet wird, kann dieser wesentliche Funktionen der Energieberechnung mitübernehmen, so daß die Kosten für die Energiemessung weiter gesenkt werden können.

Bei Verwendung eines elektronischen Meßwerks ergibt sich ferner die Möglichkeit, die gesamte Schaltung des erfindungsgemäßen Gerätes in einem Großschaltkreis zu integrieren, so daß die Kosten und der Platzbedarf des Gerätes noch weiter reduziert werden können.

Gemäß einem weiteren Vorschlag der Erfindung kann für das Gerät ein Gehäuse mit Schnappbefestigung für den Einbau in Normverteilungen verwendet werden, so daß es dann zusammen mit Sicherungen usw. in einen Stromkreis eingeschleift werden und den Energieverbrauch in diesem Stromkreis erfassen kann.

Vorzugsweise wird für das Gerät ein genormtes Gehäuse verwendet, so daß es zum Einbau in Schalttafelgeräte geeignet ist. Es können dann Meßsätze mit Schalttafel-Digital-Voltmetern usw. zusammengestellt werden.

In einer weiteren Ausgestaltung der Erfindung kann in dem Gerät ein elektronisches Meßwerk verwendet sein, das wahlweise sowohl zur Messung des Energieverbrauchs als auch der Leistung geeignet ist. Hierbei ist es zweckmäßig, daß dann beide Werte wahlweise auf ein und derselben Anzeige darstellbar sind.

Bei Verwendung eines elektronischen Meßwerkes für die Erfassung des Energieverbrauchs und der Leistung können zur Messung der Leistung die jeweils bestimmte Energiemengen repräsentierenden Verbrauchsimpulse während einer bestimmten, vorzugsweise von der Netzfrequenz abgeleiteten, Zeitdauer in einem Zähler aufsummiert und nach deren Ablauf angezeigt werden. Die von dem angeschlossenen Gerät verbrauchte Energie wird also über eine feste Zeit gemessen und als Leistung angezeigt. Die Zeitbasis wird dabei zweckmäßig von der Netzfrequenz abgeleitet.

Um den Aufwand möglichst gering zu halten, wird ein elektronisches Meßwerk mit gleichspannungsgekoppelten Eingängen verwendet, so daß auch bei stark verzerrten Strömen und Spannungen sowie bei Gleichanteilen in einem oder beiden Eingangssignalen eine richtige Anzeige erfolgt.

Anhand der Zeichnung, in der ein Ausführungsbeispiel dargestellt ist, wird die Erfindung näher erläutert.

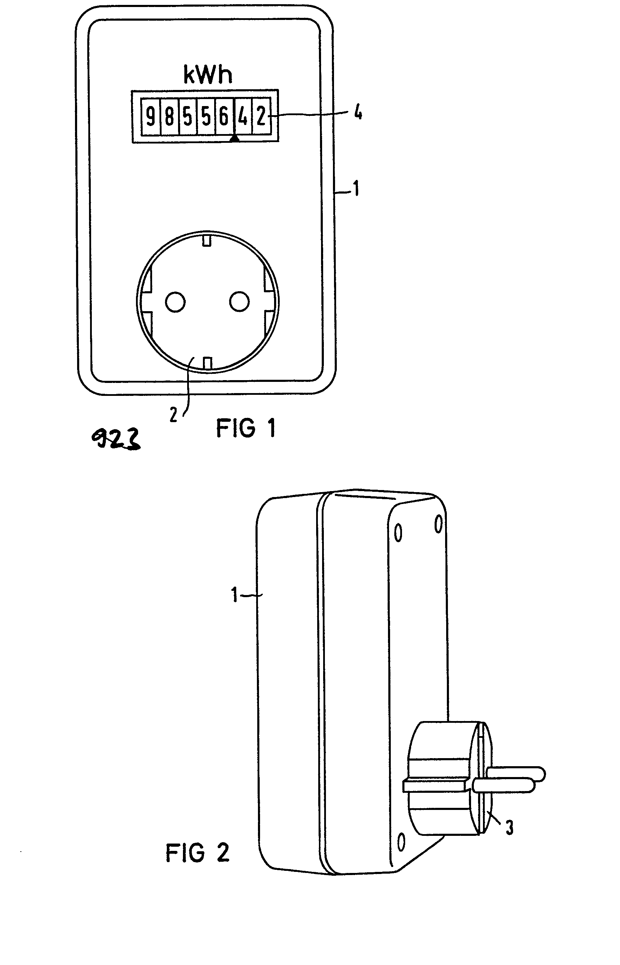

Figur 1 zeigt eine Ansicht des Gerätes mit einer im Gehäuse 1 eingeformten Schukosteckdose 2 und Figur 3 eine Ansicht von hinten auf das Gerät mit einem angeformten Schukostecker 3. Wie Figur 1 zeigt, ist im Gehäuse 1 ein Fenster 4 für die Anzeige in kWh vorgesehen. Innerhalb des Gerätes befindet sich das vorzugsweise elektronisch ausgebildete Meßwerk. Das in Figur 1 und 2 dargestellte Gerät kann also unmittelbar in eine Schukosteckdose eingeführt werden.

Es ist einleuchtend, daß im Bedarfsfalle die Schukosteckdose 2 und/oder der Schukostecker 3 getrennt von dem Gehäuse 1 des Gerätes angeordnet sein können und dann über ein Verbindungskabel mit diesen in Verbindung stehen können.

<u>Patentansprüche</u>

1. Gerät zum Erfassen, Messen und Anzeigen des Energieverbrauchs elektrischer Verbraucher, d a d u r c h   g e k e n n - z e i c h n e t ,   daß es ein nach einem an sich bekannten Prinzip arbeitendes Ein- oder Mehrphasenmeßwerk enthält, speziell einem einzelnen Verbraucher oder einer speziellen Verbrauchergruppe zugeordnet ist und nur den Verbrauch dieses einen Verbrauchers bzw. der Verbrauchergruppe erfaßt, mißt und anzeigt.

2. Gerät nach Anspruch 1, dadurch gekennzeichnet, daß es mit einem Schukostecker und einer Schukosteckdose versehen ist, so daß es zwischen einer spannungsführenden Schukosteckdose und einem Anschlußstecker eines zu messenden Verbrauchers einschaltbar ist.

3. Gerät nach Anspruch 2, dadurch gekennzeichnet, daß das Gehäuse auf einer Seite einen Schukostecker als Eingang für das Ein- oder Mehrphasenmeßwerk und auf einer anderen Seite eine Schukosteckdose zum Anschluß des zu messenden Verbrauchers aufweist.

4. Gerät nach Anspruch 2, dadurch gekennzeichnet, daß das Gehäuse über ein Zuleitungskabel mit einem Schukostecker als Eingang für das Ein- oder Mehrphasenmeßwerk in Verbindung steht, während das Gehäuse eine Schukosteckdose zum Anschluß des zu messenden Verbrauchers aufweist.

5. Gerät nach Anspruch 2, dadurch gekennzeichnet, daß das Gehäuse auf einer Seite einen Schukostecker als Eingang für das Ein- oder Mehrphasenmeßwerk aufweist, während der Anschluß des zu messenden Verbrauchers über eine Schukosteckdose erfolgt, welche mit dem Gehäuse über ein Zuleitungskabel in Verbindung steht.

6. Gerät nach Anspruch 1, dadurch gekennzeichnet, daß das Ein- oder Mehrphasenmeßwerk mit seiner Anzeige in ein an sich bekanntes Gehäuse mit Schnappbefestigung für Normverteilungen eingebaut ist.

7. Gerät nach Anspruch 6, dadurch gekennzeichnet, daß das Ein-
oder Mehrphasenmeßwerk mit seiner Anzeige in ein an sich bekanntes Norm-Schalttafel-Gehäuse, vorzugsweise 72 x 72 mm$^2$ eingebaut
ist.

8. Gerät nach Anspruch 1, dadurch gekennzeichnet, daß das Ein-
oder Mehrphasenmeßwerk mit seiner Anzeige in eine elektrische
Maschine eingebaut oder an diese angebaut ist.

9. Gerät nach Anspruch 1, dadurch gekennzeichnet, daß das Ein-
oder Mehrphasenmeßwerk mit seiner Anzeige unmittelbar in einem
Haushaltgerät, wie Heizgerät, Waschmaschine, Wäschetrockner, Geschirrspüler, Bügelmaschine, Bügeleisen oder dergleichen, eingebaut ist.

10. Gerät nach einem der Ansprüche 1 bis 9, gekennzeichnet durch
die Verwendung eines Ein- oder Mehrphasenmeßwerks mit lageunabhängigem Meßwerk.

11. Gerät nach Anspruch 10, dadurch gekennzeichnet, daß ein elektronisches Meßwerk verwendet ist.

12. Gerät nach Anspruch 10, gekennzeichnet durch die Verwendung
eines motorischen Meßwerkes.

13. Gerät nach einem der Ansprüche 1 bis 11, dadurch gekennzeichnet, daß bei elektronisch gesteuerten Maschinen oder Geräten zum
Zwecke der Energiemessung Teile der vorhandenen Elektronik, z. B.
die Anzeige, mitbenutzt sind.

14. Gerät nach einem der Ansprüche 1 bis 11, dadurch gekennzeichnet, daß bei elektronisch gesteuerten Maschinen oder Geräten,
die über einen Mikrocomputer verfügen, der Computer so programmiert ist, daß er eine Energieverbrauchsmessung mitübernimmt.

15. Gerät nach einem der Ansprüche 1 bis 14, dadurch gekennzeichnet, daß ein berührungssicheres und von jedermann gefahrlos handzuhabendes Isoliergehäuse verwendet ist, das keinerlei Bedienungsorgane aufweist.

0000923
77 P 3194 BRD

16. Gerät nach einem der Ansprüche 1 bis 15, dadurch gekennzeichnet, daß bei Verwendung eines elektronischen Meßwerkes ein an sich bekanntes Rollenzählwerk mit Schrittmotor- oder Klappankerantrieb zur Anzeige des Energieverbrauchs verwendet ist.

17. Gerät nach einem der Ansprüche 1 bis 15, dadurch gekennzeichnet, daß bei Verwendung eines elektronischen Meßwerkes eine elektronische Digitalanzeige verwendet ist.

18. Gerät nach einem der Ansprüche 1 bis 17, dadurch gekennzeichnet, daß zur Anzeige des Energieverbrauchs ein manuell oder elektrisch rückstellbares Zählwerk verwendet ist.

19. Gerät nach einem der Ansprüche 1 bis 18, dadurch gekennzeichnet, daß zur Anzeige des Energieverbrauchs ein Zählwerk verwendet ist, das sich automatisch rückstellt, sobald der Zähler an Spannung gelegt wird.

20. Gerät nach einem der Ansprüche 1 bis 19, dadurch gekennzeichnet, daß ein elektronisches Meßwerk verwendet ist, das wahlweise sowohl zur Messung des Energieverbrauchs als auch der Leistung geeignet ist.

21. Gerät nach Anspruch 20, dadurch gekennzeichnet, daß bei Verwendung eines elektronischen Meßwerkes für die Erfassung des Energieverbrauchs und der Augenblicksleistung beide Werte wahlweise auf ein und derselben Anzeige darstellbar sind.

22. Gerät nach Anspruch 20 oder 21, dadurch gekennzeichnet, daß bei Verwendung eines elektronischen Meßwerks für die Erfassung des Energieverbrauchs und der Leistung zur Messung der Leistung die jeweils bestimmte Energiemengen repräsentierenden Verbrauchsimpulse während einer bestimmten, vorzugsweise von der Netzfrequenz abgeleiteten, Zeitdauer in einem Zähler aufsummiert und nach deren Ablauf angezeigt werden.

23. Gerät nach einem der Ansprüche 11 bis 22, dadurch gekennzeichnet, daß bei Verwendung eines elektronischen Meßwerkes mit gleichspannungsgekoppelten Eingängen Maßnahmen vorgesehen sind, die verhindern, daß Meßfehler auftreten, wenn sowohl im Meßstrom als auch in der Meßspannung Gleichanteile enthalten sind.

kWh

| 9 | 8 | 5 | 5 | 6 | 4 | 2 |

4

1

2

*923*

FIG 1

1

3

FIG 2

Europäisches
Patentamt

**EUROPÄISCHER RECHERCHENBERICHT**

Nummer der Anmeldung
EP 78 10 0680
000923

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | GB - A - 376 717 (N.V. PHILIPS GLOEILAMPENFABRIEKEN) <br><br> * Seite 1, Zeilen 13 bis 45, 55 bis 87; Figur 1 * <br><br> -- | 1,6,15 |
|  | DE - A - 1 640 119 (FRANCKH'SCHE VERLAGSHANDLUNG W. KELLER & CO) <br><br> * Seite 2, letzter Absatz; Seite 4, erster und zweiter Absatz; Seite 8, letzter Absatz; Figuren 1-3 * <br><br> -- | 2-5 |
|  | DE - A - 2 137 169 (INTER CONTROL HERMANN KOEHLER ELEKTRIK GmbH & CO KG) <br><br> * Seite 2, letzter Absatz; Figuren 1-3 * <br><br> -- | 1 |
|  | DE - A - 1 541 768 (H. KUNTZE) <br><br> * Seite 2; Seite 3, erster Absatz; Figur * <br><br> ---- | 1-3 |

**KLASSIFIKATION DER ANMELDUNG (Int.Cl.²)**

G 01 R 1/20
              11/00
H 01 R 13/66

**RECHERCHIERTE SACHGEBIETE (Int. Cl.²)**

G 01 R 1/20
            11/00
            11/02
            11/04
            21/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 29-11-1978 | KUSCHBERT |

EPA form 1503.1  06.78